## Europäisches Patentamt

## European Patent Office

## Office européen des brevets

(19)

(11) Veröffentlichungsnummer: **0 087 691**

**B1**

(12)

# EUROPÄISCHE PATENTSCHRIFT

(45) Veröffentlichungstag der Patentschrift:
21.09.88

(51) Int. Cl.⁴: **H 01 L 39/24**

(21) Anmeldenummer: **83101552.4**

(22) Anmeldetag: **18.02.83**

(54) **Verfahren zur Herstellung eines stabilisierten Supraleiters mit einer diffusionshemmenden Schicht.**

(30) Priorität: **27.02.82 DE 3207159**

(43) Veröffentlichungstag der Anmeldung:
**07.09.83 Patentblatt 83/36**

(45) Bekanntmachung des Hinweises auf die Patenterteilung:
**21.09.88 Patentblatt 88/38**

(84) Benannte Vertragsstaaten:
**CH DE FR GB LI**

(56) Entgegenhaltungen:
**DE-A-2 302 249**
**US-A-4 094 060**

(73) Patentinhaber: **VACUUMSCHMELZE GMBH, Grüner Weg 37 Postfach 2253, D-6450 Hanau 1 (DE)**

(72) Erfinder: **Hillmann, Hans, Dr., Würzburger Strasse 55, D-6458 Rodenbach (DE)**
Erfinder: **Springer, Engelbert, Dr., Ulmenstrasse 23, D-6458 Rodenbach (DE)**

EP 0 087 691 B1

## Beschreibung

Die Erfindung betrifft ein Verfahren zur Herstellung eines Supraleiters, dessen supraleitendes Material aus einer mindestens zwei Elemente enthaltenden intermetallischen Verbindung besteht und der zur Stabilisierung ein bei der Betriebstemperatur des Supraleiters normalleitendes Material enthält, bei dem sich zwischen den Querschnittsbereichen mit normalleitendem und supraleitendem Material ein beispielsweise aus Tantal bestehendes Material zur Verhinderung unerwünschter Diffusion befindet, wobei der Leiterquerschnitt zunächst aus den genannten Materialien zusammengesetzt und anschließend einmal bzw. mehrere Male mit Zwischenglühungen im Sinne einer Querschnittsverringerung verformt wird, bis der Nennquerschnitt erreicht ist.

Ein derartiges Verfahren zur Herstellung eines Supraleiters ist in der deutschen Offenlegungsschrift 28 26 810 beschrieben. Hier ist ausgeführt, daß man bei der Herstellung eines stabilisierten Supraleiters zwischen die supraleitenden und die bei Betriebstemperatur normalleitenden Bereiche eine diffusionshemmende Schicht anordnen kann. Diese diffusionshemmende Schicht besteht üblicherweise aus Tantal und verhindert, daß das Zinn aus dem Bereich mit supraleitendem Material in das der Stabilisierung dienende Kupfer hineindiffundieren und so dessen Leitfähigkeit vermindern kann.

Anstelle von Tantal als diffusionshemmendes Material könnte man aus Preisgründen auch Niob verwenden, allerdings würde dann das Zinn mit der diffusionshemmenden Schicht eine supraleitende $Nb_3Sn$-Schicht bilden, die im Betrieb zu "großflächigen" supraleitenden Strömen führt. Dies hat zur Folge, daß Abschirmeffekte, Feldänderungen beim Auferregen von Magneten sowie Probleme bei der Stromeinspeisung entstehen.

Aufgabe der Erfindung ist es, zum Aufbau der diffusionshemmenden Schicht auch preisgünstigere Materialien als z. B. Tantal verwenden zu können, ohne daß der geschilderte nachteilige Effekt auftritt. Weiterhin erreicht man bei dem erfindungsgemäßen Verfahren, daß mit der diffusionshemmenden Schicht verschieden große und verschieden geformte (z.B. 6-eckige) Bereiche mit normalleitendem Material von den Bereichen mit supraleitendem Material getrennt werden können. Unabhängig von der Formgebung der diffusionshemmenden Schicht kann diese aus untereinander gleichartigen Elementen aufgebaut werden, so daß die Einbringung von diffusionshemmenden Schichten bei unterschiedlichen Leitern kostengünstig und schnell vorgenommen werden kann. Außerdem ergibt sich bei der Anwendung des vorliegenden Verfahrens eine größere Sicherheit gegen die Bildung von Rissen und Brüchen in der diffusionshemmenden Schicht.

Erfindungsgemäß besteht das Verfahren darin, daß zur Bildung der diffusionshemmenden Schicht vor Erreichen des Nennquerschnittes zwischen die Bereiche mit normalleitendem und supraleitendem Material mehrere stabförmige Segmente aus dem diffusionshemmenden Material angeordnet werden, die erst durch die nachfolgende Querschnittsverringerung sich zu einer diffusionshemmenden Schicht verbinden.

Besonders vorteilhaft ist es, wenn abwechselnd Tantal und Niob-Stäbe verwendet werden. Selbst wenn zu 2/3 oder 3/4 Niob-Stäbe vorgesehen sind, verhält sich die diffusionshemmende Schicht weitgehend so, als ob sie vollständig aus Tantal bestünde. Auf dem Niob bilden sich bei der Reaktionsglühung zwar supraleitende Schichten aus $Nb_3Sn$, durch die aus Tantal bestehenden Bereiche der diffusionshemmenden Schicht werden jedoch zusammenhängende supraleitende Schichten vermieden, so daß sich keine großflächigen, supraleitenden Ströme ausbilden können, die zu Instabilitäten, Abschirmeffekten und Verlusten führen würden.

Als Ausführungsbeispiel ist in der Zeichnung der Querschnitt eines Supraleiters dargestellt. Hier besteht der innere Querschnittsbereich 1 aus einem gut leitfähigen Kupfer, das zur Stabilisierung des Supraleiters dient und bei dessen Betriebstemperatur normalleitend ist. Der äußere Querschnittsbereich 2 besteht aus einer Kupfer-Zinn-Bronze 3, in die Filamente 4 aus Niob eingebettet sind.

Zwischen dem inneren Querschnittsbereich 1 und dem äußeren Querschnittsbereich 2 werden nun vor Erreichen der Endabmessung des durch Verformen stufenweise zu verringernden Querschnittes mehrere stabförmige Segmente eingelegt. Im Ausführungsbeispiel bestehen die stabförmigen Segmente 5 aus Niob und die stabförmigen Segmente 6 aus Tantal. Nach Zusammensetzung des Leiterquerschnittes durch die genannten Materialien wird dann der Leiter durch Pessen oder Ziehen so verformt, daß sich sein Querschnitt verringert. Hier können mehrere Preß- oder Ziehvorgänge mit zwischengeschalteten Zwischenglühungen vorgenommen werden.

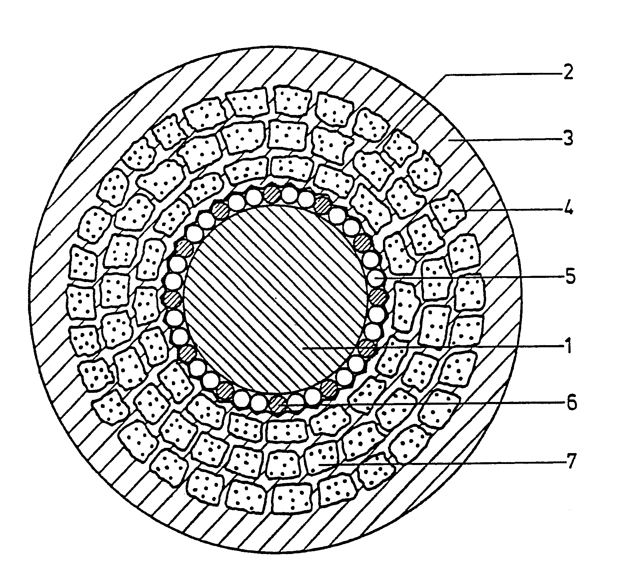

Aus Figur 1 ist zu ersehen, daß die Filamente 4 in einzelnen Bereichen 7 zusammengefaßt sind. Diese Anordnung ergibt sich dadurch, daß bereits gepreßte oder gezogene Stäbe aus Filamenten mit Kupfer-Zinn-Bronze zum Aufbau des endgültigen Querschnittes genommen worden sind.

Die stabförmigen Segmente 5 und 6 sind im Ausführungsbeispiel als runde Stäbe dargestellt, sie können allerdings auch andere Querschnitte aufweisen. Wesentlich ist, daß die spätere, diffusionshemmende Schicht aus mehreren, nebeneinander angeordneten Segmenten besteht. Diese Segmente werden bei der Weiterverformung des Leiterquerschnittes zusammengepreßt, verschweißen miteinander und ergeben beim fertigen Supraleiter eine zusammenhängende Schicht. Durch diesen Aufbau des Supraleiters ist es nicht nur möglich, die diffusionshemmende Schicht bereichsweise aus unterschiedlichen Materialien herzustellen, sondern es sind alle eingangs geschilderten Vorteile einschließlich der Sicherheit gegen Risse und Brüche und der Freiheit in der Formgebung für den Querschnittsbereich 1 vorhanden. Zur weiteren Vereinfachung bei der Herstellung des Supraleiters können die einzelnen, die diffusionshemmende Schicht bildenden Stäbe durch das Umwickeln einer beispielsweise aus Kupfer-Zinn-Bronze bestehenden Folie am Umfang des inneren Querschnittsbereiches 1 zusammengehalten werden.

Die stabförmigen Segmente 5 und 6 sind im Ausführungsbeispiel parallel zur Mittelachse des Supraleiters angeordnet. Sie können in gleicher Weise jedoch auch spiralförmig den Querschnittsbereich 1 umschließen.

Das Verfahren ist für alle Supraleiter vorteilhaft, bei denen das Supraleitermaterial aus einer mindestens zwei Elemente enthaltenden supraleitenden intermetallischen Verbindung besteht. Es ist also für $Nb_3Sn$ oder $V_3Ga$ in gleicher Weise anwendbar und verhindert bei allen diesen Supraleitermaterialien, daß die zur Bildung der intermetallischen Phase vorzusehende Wärmebehandlung dazu führt, daß niedrigschmelzendes Material in das zur Stabilisierung vorgesehene normalleitende Stabilisierungsmaterial eindringt.

**Patentansprüche**

1. Verfahren zur Herstellung eines Supraleiters, dessen supraleitendes Material aus einer mindestens zwei Elemente enthaltenden intermetallischen Verbindung besteht und der zur Stabilisierung ein bei der Betriebstemperatur des Supraleitermaterials normalleitendes Material enthält, bei dem sich zwischen den Querschnittsbereichen mit normalleitendem (1) und supraleitendem (2) Material ein beispielsweise aus Tantal bestehendes Material zur Verhinderung unerwünschter Diffusion befindet, wobei der Leiterquerschnitt zunächst aus den genannten Materialien zusammengesetzt und anschließend einmal bzw. mehrere Male mit Zwischenglühungen im Sinne einer Querschnittsverringerung verformt wird, bis der Nennquerschnitt erreicht ist, dadurch gekennzeichnet, daß zur Bildung der diffusionshemmenden Schicht vor Erreichen des Nennquerschnittes zwischen die Bereiche mit normalleitendem (1) und supraleitendem (2) Material mehrere stabförmige Segmente (5, 6) aus dem diffusionshemmenden Material angeordnet werden, die erst durch die nachfolgende Querschnittsverringerung sich zu einer diffusionshemmenden Schicht verbinden.

2. Verfahren nach Anspruch 1, dadurch gekennzeichnet, daß zwischen dem Querschnittsbereich (1) mit normalleitendem Material und dem Querschnittsbereich (2) mit supraleitendem Material zur Bildung einer diffusionshemmenden Schicht stabförmige Segmente (5, 6) mit einem runden oder mehreckigen Querschnitt eingelegt werden.

3. Verfahren nach Anspruch 1, dadurch gekennzeichnet, daß zum Halten der stabförmigen Segmente (5, 6) diese mit einer Folie umwickelt werden.

4. Verfahren nach Anspruch 3, dadurch gekennzeichnet, daß die Folie aus Kupfer-Zinn-Bronze besteht.

5. Verfahren nach Anspruch 1, dadurch gekennzeichnet, daß stabförmige Segmente (5) aus Niob abwechselnd mit stabförmigen Segmenten (6) aus Tantal nebeneinandergelegt werden, so daß die sich später bildende diffusionshemmende Schicht einzelne Bereiche aus Niob mit dazwischenliegenden Bereichen aus Tantal besitzt.

**Claims**

2. Method of producing a superconductor whose superconducting material consists of an intermetallic compound containing at least two elements and which, for stabilisation, contains a material which is normally conducting at the working temperature of the superconductor, in which superconductor a material for preventing undesirable diffusion, consisting, for example of tantalum, is located between the cross-sectional regions containing normally conducting material (1) and superconducting material (2), the conductor cross-section being made up initially from the said materials and subsequently being deformed once or several times with intermediate annealings to bring about a cross-section reduction until the nominal cross-section is reached, characterised in that, to form the diffusion-inhibiting layer before the nominal cross-section is reached, several rod-shaped segments (5, 6) consisting of the diffusion-inhibiting material, which combine to form a diffusion-inhibiting layer only as a result of the subsequent cross-section reduction, are provided between the regions containing normally conducting material (1) and superconducting material (2).

2. Method according to Claim 1, characterized in that rod-shaped segments (5, 6) with a round or polygonal cross-section are inserted between the cross-sectional region (1) containing normally conducting material and the cross-sectional region (2) containing superconducting material to form a diffusion-inhibiting layer.

3. Method according to Claim 1, characterised in that to hold the rod-shaped segments (5, 6), the latter are wrapped round with a foil.

4. Method according to Claim 3, characterised in that the foil consists of copper-tin bronze.

5. Method according to Claim 1, <u>characterized</u> <u>in</u> that rod-shaped segments (5) consisting of niobium are alternately laid alongside rod-shaped segments (6) consisting of tantalum, so that the diffusion-inhibiting layer formed subsequently has individual regions consisting of niobium with regions consisting of tantalum situated in between.

## Revendications

1. Procédé pour fabriquer un supraconducteur dont le matériel supraconducteur est constitué par une combinaison inter-métallique comprenant deux éléments, et qui comprend, pour permettre la stabilisation, un matériau normalement conducteur à la température de fonctionnement du matériau supraconducteur, procédé dans lequel, entre les zones de section transversale comportant le matériau normalement conducteur (1) et le matériau supraconducteur (2), se trouve un matériau constitué par exemple de tantale pour empêcher une diffusion non souhaitable, la section transversale du conducteur étant tout d'abord composée à partir des matériaux précités et ensuite façonnée en une ou plusieurs fois avec des recuits intermédiaires, dans le sens d'une réduction de cette section transversale, jusqu'à ce que la section transversale nominale soit obtenue, procédé caractérisé en ce que, pour constituer la barrière de diffusion, plusieurs segments en forme de barreaux (5, 6) du matériau empêchant la diffusion, sont disposés, avant que la section transversale nominale ait été obtenue, entre les zones comportant le matériau normalement conducteur (1) et le matériau supraconducteur (2), ces barreaux ne s'assemblant pour constituer une barrière de diffusion, qu'après la réduction ultérieure de la section transversale.

2. Procédé selon la revendication 1 , caractérisé en ce qu'entre la zone de section transversale (1) avec le matériau normalement conducteur et la zone de section transversale (2) avec le matériau supraconducteur, des segments en forme de barreaux (5, 6), avec une section transversale ronde ou polygonale, sont insérés pour constituer une barrière de diffusion.

3. Procédé selon la revendication 1, caractérisé en ce que, pour maintenir les segments en forme de barreaux (5, 6), ces segments sont enveloppés avec une feuille métallique.

4. Procédé selon la revendication 3, caractérisé en ce que la feuille métallique est en bronzecuivre-étain.

5. Procédé selon la revendication 1, caractérisé en ce que des segments en forme de barreaux (5) en niobium sont alternativement juxtaposés avec des segments en forme de barreaux (6) en tantale, de sorte que la barrière de diffusion se formant ultérieurement, comporte des zones individuelles en niobium avec des zones en tantale intercalées.